(19) **Europäisches Patentamt / European Patent Office / Office européen des brevets**

(11) **EP 1 620 577 B1**

(12) **FASCICULE DE BREVET EUROPEEN**

(45) Date de publication et mention de la délivrance du brevet:
**24.08.2011 Bulletin 2011/34**

(21) Numéro de dépôt: **04742576.4**

(22) Date de dépôt: **27.04.2004**

(51) Int Cl.:
*C23C 16/26* (2006.01)    *C23C 16/44* (2006.01)
*C04B 35/83* (2006.01)    *G05B 1/00* (2006.01)

(86) Numéro de dépôt international:
**PCT/FR2004/001009**

(87) Numéro de publication internationale:
**WO 2004/097065 (11.11.2004 Gazette 2004/46)**

(54) **COMMANDE OU MODELISATION DE PROCEDE D'INFILTRATION CHIMIQUE EN PHASE VAPEUR POUR LA DENSIFICATION DE SUBSTRATS POREUX PAR DU CARBONE.**

STEUERUNG ODER MODELIERUNG VON VERFAHREN ZUR VERDICHTUNG VON PORÖSEN SUBSTRATEN MIT KOHLENSTOFF MITTELS CHEMISCHEN GASPHASENINFILTRATION

CONTROL OR MODELING OF A METHOD FOR CHEMICAL INFILTRATION IN A VAPOR PHASE FOR THE DENSIFICATION OF POROUS SUBSTRATES BY CARBON

(84) Etats contractants désignés:
**AT BE BG CH CY CZ DE DK EE ES FI FR GB GR HU IE IT LI LU MC NL PL PT RO SE SI SK TR**

(30) Priorité: **28.04.2003 FR 0305194**

(43) Date de publication de la demande:
**01.02.2006 Bulletin 2006/05**

(73) Titulaire: **MESSIER-BUGATTI**
**78140 Vélizy Villacoublay (FR)**

(72) Inventeurs:
• **SION, Eric**
**F-67380 Lingolsheim (FR)**
• **MARQUAIRE, Paul-Marie**
**F-54000 NANCY (FR)**
• **FOURNET, René**
**F-54270 ESSEY LES NANCY (FR)**
• **COME, Guy-Marie**
**F-54000 NANCY (FR)**

(74) Mandataire: **Joly, Jean-Jacques et al**
**Cabinet Beau de Loménie**
**158, rue de l'Université**
**75340 Paris cedex 07 (FR)**

(56) Documents cités:
**WO-A-96/15285**    **US-A- 6 001 419**

• GLASIER G F ET AL: "Formation of pyrolytic carbon during the pyrolysis of ethane at high conversions" CARBON, XX, XX, vol. 39, no. 1, janvier 2001 (2001-01), pages 15-23, XP004319819 ISSN: 0008-6223
• BECKER A ET AL: "Chemistry and kinetics of chemical vapor deposition of pyrocarbon--II pyrocarbon deposition from ethylene, acetylene and 1,3-butadiene in the low temperature regime" CARBON, ELSEVIER SCIENCE PUBLISHING, NEW YORK, NY, US, vol. 36, no. 3, 1998, pages 177-199, XP004118837 ISSN: 0008-6223
• DELHAES P: "Chemical vapor deposition and infiltration processes of carbon materials" CARBON, XX, XX, vol. 40, no. 5, avril 2002 (2002-04), pages 641-657, XP004345118 ISSN: 0008-6223

EP 1 620 577 B1

**Description**

<u>Arrière-plan de l'invention</u>

L'invention concerne la densification de substrats poreux par du carbone pyrolytique, ou pyrocarbone (PyC), déposé au sein de la porosité des substrats par infiltration chimique en phase vapeur.

Un domaine particulier d'application de l'invention est la réalisation de pièces en matériau composite par densification de substrats fibreux poreux, notamment de substrats en fibres de carbone, par une matrice PyC obtenue par infiltration chimique en phase vapeur. On obtient alors des pièces en matériau composite carbone/carbone (C/C). Du fait de ses propriétés thermostructurales, le matériau composite C/C convient pour la réalisation de pièces structurelles susceptibles en service d'être exposées à des températures élevées, notamment des pièces d'ensembles propulsifs ou de structure dans le domaine aérospatial. Les caractéristiques en friction des matériaux composites C/C les rendent également aptes à constituer des pièces de friction pour freins et embrayage, notamment des disques de freins d'avions ou de véhicules terrestres.

Le procédé d'infiltration chimique en phase vapeur (ou procédé CVI pour "Chemical Vapour Infiltration") est bien connu. Il consiste à placer un ou plusieurs substrats poreux à densifier à l'intérieur d'un four dans lequel est introduite une phase gazeuse réactionnelle dont au moins un constituant est un précurseur du matériau de la matrice à déposer au sein de la porosité des substrats. Les conditions de débit, de température et de pression sont déterminées pour permettre à la phase gazeuse de diffuser au sein de la porosité des substrats et y former le dépôt souhaité par décomposition d'un de ses constituants ou par réaction entre plusieurs constituants.

Pour la formation d'une matrice PyC, on utilise une phase gazeuse réactionnelle contenant un ou plusieurs hydrocarbures gazeux susceptibles de donner un dépôt carbone par décomposition. Un exemple typique de phase gazeuse réactionnelle est un mélange de méthane et de propane dans lequel le propane agit comme "dopant" source principale de PyC et le méthane agit essentiellement comme diluant, favorisant la diffusion de la phase gazeuse dans la porosité des substrats et fournissant aussi une fraction du PyC déposé. Le procédé CVI PyC (dépôt de matrice PyC par CVI) est conduit généralement à une température comprise entre 950°C et 1100°C, sous une pression inférieure à 10 kPa.

Il existe plusieurs procédés CVI PyC, notamment le procédé isotherme et le procédé à gradient de température.

Dans le procédé isotherme, les substrats à densifier sont maintenus à chaque instant à une température sensiblement uniforme dans tout leur volume. Un inconvénient de ce procédé réside dans l'impossibilité, en pratique, de réaliser une densification uniforme. En effet, le matériau de la matrice a tendance à se déposer de façon préférentielle au sein de la porosité proche de la surface extérieure du substrat. L'obstruction progressive de la porosité de surface rend l'accès de la phase gazeuse réactionnelle au sein du substrat de plus en plus difficile avec, pour résultat, un gradient de densification entre la surface et le coeur du substrat. Il peut certes être procédé une ou plusieurs fois à un usinage de surface ou écroûtage du substrat au cours du processus de densification afin de réouvrir la porosité de surface. Mais cela requiert l'interruption du processus pendant la durée nécessaire à l'extraction du substrat de l'installation de densification, son refroidissement, l'écroûtage, la réintroduction du substrat dans l'installation, et le retour à la température voulue. Le procédé CVI PyC isotherme est donc d'une durée particulièrement longue. Au stade industriel, la densification de pièces telles que des disques de freins d'avions en composite C/C par ce procédé nécessite couramment plusieurs centaines d'heures.

Avec un procédé à gradient de température, il est permis dans une large mesure de limiter l'inconvénient précité du procédé isotherme. Une différence de température est établie entre une partie interne du substrat, plus chaude, et la surface du substrat exposée à la phase gazeuse réactionnelle. Le matériau de la matrice se dépose alors préférentiellement dans la partie interne plus chaude. En contrôlant la température de surface du substrat de sorte qu'elle soit inférieure au seuil de décomposition ou réaction de la phase gazeuse, au moins pendant une première partie du processus de densification, on peut faire en sorte que le front de densification progresse de l'intérieur vers la surface du substrat au fur et à mesure du déroulement du processus. De façon connue, le gradient de température peut être obtenu en plaçant un ou plusieurs substrats autour d'un suscepteur couplé à un inducteur avec une face interne du ou des substrats en contact avec le suscepteur. Il est possible également d'obtenir un gradient de température par couplage inductif direct entre un inducteur et le substrat en cours de densification, lorsque la nature de celui-ci le permet. Ces techniques sont décrites notamment dans les documents FR-A-2 711 647 et US-A-5 348 774.

Dans le document US 5 348 774, le chauffage des substrats est réalisé à la fois par couplage avec un suscepteur et par couplage direct avec les substrats au fur et à mesure de la progression du front de densification. Des moyens sont prévus pour mesurer la variation de poids des substrats de façon continue afin de surveiller l'évolution du processus de densification. En fonction de la variation de poids mesurée, le processus peut être optimisé, en particulier en ce qui concerne sa durée, par action sur des paramètres de densification, notamment la puissance fournie à l'inducteur. La surveillance de la variation de poids des substrats permet également de déterminer la fin du processus de densification. Le procédé à gradient de température permet certes d'obtenir une densification moins hétérogène, en comparaison avec le procédé isotherme, mais ne peut être mis en oeuvre qu'avec des substrats de forme particulière, notamment des substrats annulaires.

Une variation des paramètres de densification tout au long d'un procédé CVI est envisagée dans le document US 6 001 419. Le but poursuivi dans ce document est de contrôler la microstructure du matériau déposé. Dans le cas du PyC, on sait en effet qu'en modifiant les conditions d'infiltration, on peut notamment obtenir un pyrocarbone de type laminaire lisse, laminaire sombre, laminaire rugueux ou isotrope. Or la microstructure du pyrocarbone est une caractéristique importante au regard des propriétés du substrat densifié. Ainsi, dans le cas de pièces en matériau composite carbone-carbone, on recherche souvent une microstructure de type laminaire rugueux, notamment en raison de sa faculté à être graphitée par traitement thermique.

Le procédé du document US 6 001 419 s'avère efficace pour contrôler la microstructure des PyC déposé, mais présente aussi l'avantage de permettre une réduction sensible de la durée totale du processus de densification. La variation des paramètres de densification est réalisée suivant un modèle prédéfini.

Objet et résumé de l'invention

L'invention a pour but de permettre une commande en temps réel ou une modélisation (ou prédéfinition) d'un procédé de densification de substrats poreux par du carbone pyrolytique afin d'optimiser les paramètres d'infiltration dans le but notamment de diminuer la durée totale de la densification.

L'invention vise plus particulièrement la réalisation d'une telle commande ou d'une telle modélisation de façon auto-adaptative en tenant compte des conditions réelles du déroulement du processus d'infiltration chimique en phase vapeur.

Ce but est atteint grâce à un procédé comprenant : le logement dans un four d'un chargement comprenant un ou plusieurs substrats poreux à densifier ; le chauffage du ou des substrats ; l'admission dans le four d'une phase gazeuse réactionnelle contenant au moins un hydrocarbure précurseur de carbone ; le réglage de la pression dans le four pour permettre à la phase gazeuse de diffuser au sein de la porosité du ou des substrats chauffés afin d'y former un dépôt de carbone pyrolytique ; et l'extraction de gaz effluents hors du four par une conduite d'extraction reliée à une sortie du four ;

procédé selon lequel, conformément à l'invention, on mesure la teneur des gaz effluents en au moins un composé choisi parmi l'allène, le propyne et le benzène ; et, en fonction de la teneur mesurée, on commande le procédé par réglage d'au moins un paramètre choisi parmi : le débit de phase gazeuse réactionnelle admise dans le four, le débit d'au moins un constituant de la phase gazeuse admise dans le four, la température de chauffage du ou des substrats, la pression régnant dans le four, et le temps de séjour de la phase gazeuse dans le four.

Il a été mis en évidence par la déposante que, parmi les espèces contenues dans les gaz effluents provenant de décompositions et recompositions de constituants de la phase gazeuse réactionnelle, l'allène, le propyne et le benzène constituent de bons indicateurs de la cinétique de dépôt du carbone pyrolytique, et que la teneur des gaz effluents en ces composés peut être assez aisément mesurée.

Le procédé selon l'invention permet une optimisation en temps réel du procédé conduisant à une réduction de la durée totale du procédé jusqu'à obtention d'une densité souhaitée. Outre une réduction du temps de fabrication de pièces densifiées et, par conséquent, une meilleure disponibilité de l'installation de densification, le procédé selon l'invention permet, pour un cycle de densification donné, une économie substantielle d'énergie nécessaire au chauffage et de consommation de phase gazeuse réactionnelle.

La commande du procédé est avantageusement réalisée de manière à maintenir la teneur mesurée à une valeur sensiblement constante.

La teneur en allène, propyne ou benzène peut être mesurée dans une conduite en dérivation de la canalisation d'extraction des gaz effluents. La mesure peut être effectuée par exemple par chromatographie en phase gazeuse.

Selon un mode particulier de mise en oeuvre du procédé, la commande est réalisée par réglage du débit de phase gazeuse réactionnelle ou du débit d'un constituant de la phase gazeuse en fonction de la teneur mesurée en allène ou propyne.

Selon un autre mode particulier de mise en oeuvre du procédé, la commande est réalisée par réglage de la température, de la pression ou du temps de séjour de la phase gazeuse, en fonction de la teneur mesurée en benzène.

La phase gazeuse comprend au moins un précurseur de carbone pyrolytique choisi de préférence parmi les alcanes, alcynes et alcènes, et plus particulièrement le propane, le butane et l'éthane dilué dans du méthane ou gaz naturel ; ou dans un gaz inerte, par exemple azote.

Avantageusement encore, on détecte la fin du processus de densification par l'impossibilité de maîtriser l'évolution de la teneur mesurée par réglage du paramètre choisi. On peut ainsi déterminer la durée du processus de densification.

Le procédé conforme à l'invention permet de commander en temps réel et de façon auto-adaptative les conditions de densification d'un ou plusieurs substrats dans une installation d'infiltration chimique en phase vapeur.

Pour une installation donnée d'infiltration chimique en phase vapeur et pour un chargement type de substrats, le procédé conforme à l'invention permet, en effectuant un ou plusieurs cycles initiaux de densification, de réaliser une modélisation du processus de densification. Le modèle ou gabarit de variation de paramètre(s) ainsi prédéfini est mémorisé pour être ensuite appliqué sur des chargements de substrats semblables sans avoir à analyser les gaz effluents. La durée du processus de densification éventuellement déterminée lors de l'étape de modélisation peut aussi être mémorisée.

Brève description des dessins

L'invention sera mieux comprise à la lecture de la description faite ci-après, à titre indicatif mais non limitatif, en référence aux dessins annexés sur lesquels :

- la figure 1 est une vue très schématique d'une installation d'infiltration chimique en phase vapeur permettant la mise en oeuvre d'un procédé conforme à l'invention ;
- les figures 2 à 6 sont des courbes illustrant l'influence de la masse et de la densité des substrats sur la teneur des gaz effluents en allène et propyne ;
- la figure 7 est une courbe illustrant le contrôle du procédé de densification par variation du débit massique d'un constituant de la phase gazeuse, à partir de la mesure de la teneur des gaz effluents en allène et propyne ; et
- la figure 8 est une courbe illustrant le contrôle du procédé de densification par variation de la température à partir de la mesure de la teneur des gaz effluents en benzène.

Description détaillée de modes de réalisation de l'invention

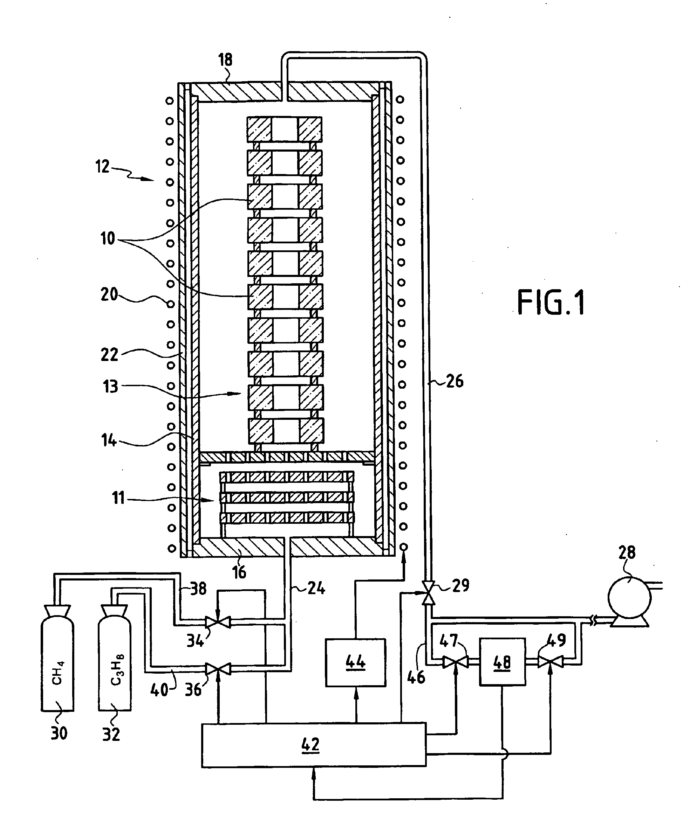

Une installation d'infiltration chimique en phase vapeur est représentée très schématiquement sur la figure 1.

Des substrats poreux 10 à densifier sont logés à l'intérieur d'un four 12 comprenant une paroi latérale cylindrique 14, un fond 16 et un couvercle 18. La paroi 14 est en graphite et forme un suscepteur couplé inductivement avec un inducteur 20 séparé de la paroi 14 par un isolant 22. L'ensemble est logé dans une enveloppe métallique (non représentée).

Les substrats 10 sont par exemple des préformes annulaires en fibres de carbone. Les préformes sont disposées en une pile verticale en étant séparées les une des autres par des cales.

Une phase gazeuse réactionnelle est admise dans le four par une canalisation d'amenée 24 raccordée à un orifice d'entrée s'ouvrant dans le fond 16. A la partie inférieure du four, la phase gazeuse traverse une zone de préchauffage 11 avant d'atteindre la zone 13 de chargement des substrats 10. La zone de préchauffage comprend par exemple plusieurs plateaux perforés en graphite qui sont portés à la température du four. Au contact de ces plateaux, la phase gazeuse réactionnelle est préchauffée avant de parvenir dans la zone de chargement.

Les gaz effluents sont extraits à travers un orifice de sortie s'ouvrant dans le couvercle 18 et raccordé à une canalisation d'extraction 26. Celle-ci relie le four à un dispositif d'aspiration 28 tel qu'une pompe. Une vanne 29 montée sur la conduite 26 permet de régler le niveau de pression dans le four. Un ou plusieurs dispositifs d'épuration, notamment un piège à goudrons (non représentés) peuvent être montés sur la canalisation 26 en amont du dispositif d'aspiration .

La phase gazeuse réactionnelle est constituée par un mélange gazeux dont les constituants sont stockés dans des réservoirs 30, 32. On pourra utiliser par exemple une phase gazeuse constituée par un mélange de méthane ($CH_4$) et de propane ($C_3H_8$). Le propane, ou gaz dopant, constitue alors le principal précurseur de carbone pyrolytique ou pyrocarbone (PyC) par un processus de décomposition dans les conditions de température et de pression régnant dans le four. Le méthane a une fonction de diluant favorisant la diffusion de la phase gazeuse au sein de la porosité des substrats et contribue également pour une moindre part, à la formation de PyC. On notera que le butane $C_4H_{10}$, le propylène ou l'éthane $C_2H_6$ peuvent aussi être utilisés comme gaz dopant à la place ou avec le propane. Des vannes 34, 36 sont montées sur des conduites 38, 40 reliant les réservoirs 30, 32 de méthane et de propane à la canalisation d'amenée de manière à pouvoir réguler les débits massiques respectifs de méthane et de propane. Les vannes 34, 36 sont commandées par un circuit de commande 42. Celui-ci est également relié à un circuit 44 d'alimentation en courant de l'inducteur 20, afin de commander la puissance de chauffage du four, et à la vanne 29 afin de commander la pression dans le four. Le four est muni de capteurs de température et de pression (non représentés) fournissant au circuit de commande 42 des signaux représentatifs de la température et de la pression dans le four. Le capteur de température peut être constitué par au moins un pyromètre optique supporté par le couvercle 18 et mesurant la température de surface des substrats. Le capteur de pression peut être logé en sortie du four.

Une installation telle que décrite ci-avant est bien connue en elle-même.

Une conduite 46 est branchée en dérivation sur la canalisation d'extraction 26. Un dispositif 48 est monté sur la conduite 46 entre deux vannes 47 et 49 afin de mesurer la teneur des gaz effluents en une ou plusieurs espèces gazeuses sélectionnées représentatives de la cinétique de dépôt de PyC au sein des substrats 10. Le dispositif de mesure est par exemple un dispositif de chromatographie en phase gazeuse. On pourrait aussi utiliser un dispositif d'analyse par des méthodes spectroscopiques.

Le dispositif 48 est relié au circuit de commande 42 afin de fournir à ce dernier un signal représentatif de la teneur ou des teneurs mesurées. Les mesures sont effectuées de façon périodique par ouverture des vannes 47, 49 par le circuit de commande 42.

Le processus d'infiltration chimique en phase vapeur dépend d'un ensemble de paramètres, notamment :

- le débit de phase gazeuse réactionnelle ;
- le débit particulier d'un ou plusieurs constituants de la phase gazeuse, notamment, dans l'exemple ci-dessus, le débit de gaz dopant ;
- la température de chauffage des substrats ;
- la pression régnant dans le four ; et
- le temps de séjour de la phase gazeuse réactionnelle dans le four.

On notera que ces deux derniers paramètres, pression P et temps de séjour $\tau$ sont reliés l'un à l'autre puisque le temps de séjour est usuellement défini par la relation $\tau = \dfrac{V}{Q}$, dans laquelle V est le volume interne du four susceptible d'être parcouru par la phase gazeuse et Q le débit de phase gazeuse admise. Le volume V inclut le volume de porosité accessible des substrats chargés dans le four. Le temps de séjour $\tau$ dépend du degré de remplissage du four et évolue dans une certaine mesure au long du processus de densification des substrats, toutes choses égales par ailleurs.

La déposante a mis en évidence que, parmi les espèces contenues dans les gaz effluents, l'allène a-$C_3H_4$, le propyne p-$C_3H_4$ et le benzène $C_6H_6$ ont des teneurs qui sont représentatives de la cinétique de formation du PyC et varient de façon sensible en fonction d'un ou plusieurs des paramètres de densification précités.

Des essais ont été effectués au moyen d'une installation du type de celle de la figure 1 mais de taille réduite par rapport à une installation industrielle, le volume $V_R$ du four étant de 640 cm$^3$, dont 50 cm$^3$ correspondant à la zone de préchauffage. Le volume $V_R$ du four est lié au volume V défini ci-avant par la relation $V_R = V + V_s$ dans laquelle $V_s$ est le volume représenté par les parties de substrats sans porosité accessible.

Les substrats poreux utilisés pour les essais étaient des structures fibreuses annulaires en fibres de carbone de diamètre extérieur égal à 35 mm, de diamètre intérieur égal à 15 mm et d'épaisseur égale à 15 mm. Le taux volumique de porosité initiale des substrats, c'est-à-dire la fraction du volume apparent des substrats occupée par la porosité était d'environ 80 %, conférant aux substrats une densité initiale environ égale à 0,4. Les substrats étaient disposés en pile verticale en étant séparés les uns des autres par des cales en graphite d'épaisseur égale à 3 mm, sans obturation des intervalles entre substrats.

Les substrats ont été obtenus par découpe dans des plaques formées de strates fibreuses superposées liées entre elles par aiguilletage. Chaque strate était sous forme d'une nappe multidirectionnelle constituée de deux nappes unidirectionnelles, c'est-à-dire formées d'éléments filamentaires disposés parallèlement à une même direction, les nappes unidirectionnelles étant superposées dans des directions différentes et liées entre elles par aiguilletage léger. On notera que ce type de structure fibreuse est bien connu dans le domaine de la fabrication de disques de frein en matériau composite C/C.

Essais 1

Des processus d'infiltration en phase vapeur ont été mis en oeuvre avec des substrats à des stades différents de densification et, dans chaque cas, avec des chargements différents.

Les paramètres du procédé étaient fixés ainsi : phase gazeuse réactionnelle constituée d'un mélange $CH_4/C_3H_8$ dans des proportions volumiques respectives 0,9/0,1, température égale à environ 1000°C, pression environ égale à 1,3 kPa et temps de séjour environ égal à 1 s.

Le tableau I ci-dessous indique la teneur totale mesurée en allène et propyne pour des substrats de densités d différentes allant de 0,4 à 1,55, c'est-à-dire en allant de substrats en début de densification à des substrats en fin de densification, et pour des rapports $m_o/V_R$ différents, $m_o$ étant la masse totale initiale des substrats chargés dans le four et $V_R$ le volume du four.

La teneur globale en allène et propyne est exprimée en pourcentage volumique dans des gaz effluents.

## Tableau I

| $m_o/V_R$ $10^{-2}$ g/cm³ \ Densité (d) | 0,4 | 0,7 | 0,9 | 1,35 | 1,55 |
|---|---|---|---|---|---|
| 1,56 | 0,61 | | | | |
| 2,34 | | 0,72 | | | |
| 2,81 | 0,43 | | | | |
| 3,13 | | | 0,69 | | |
| 4,06 | 0,24 | | | | |
| 4,69 | | 0,5 | | | |
| 5,47 | 0,14 | | | | |
| 7,03 | | 0,37 | | | |
| 7,81 | | | 0,45 | | |
| 9,38 | | 0,15 | | 0,80 | |
| 10,94 | | | 0,33 | | 0,84 |
| 15,63 | | | | 0,60 | 0,80 |
| 21,09 | | | | | 0,76 |

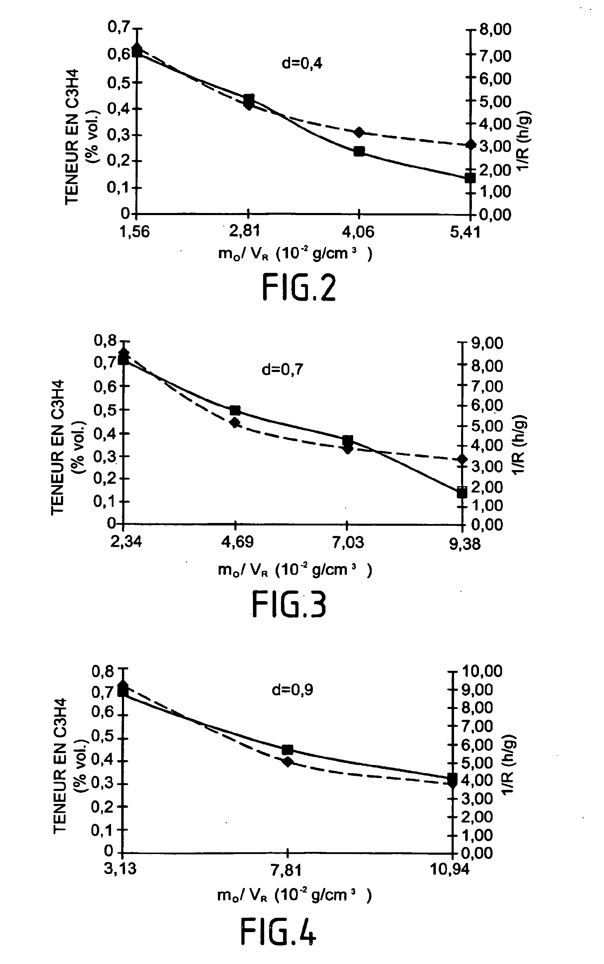

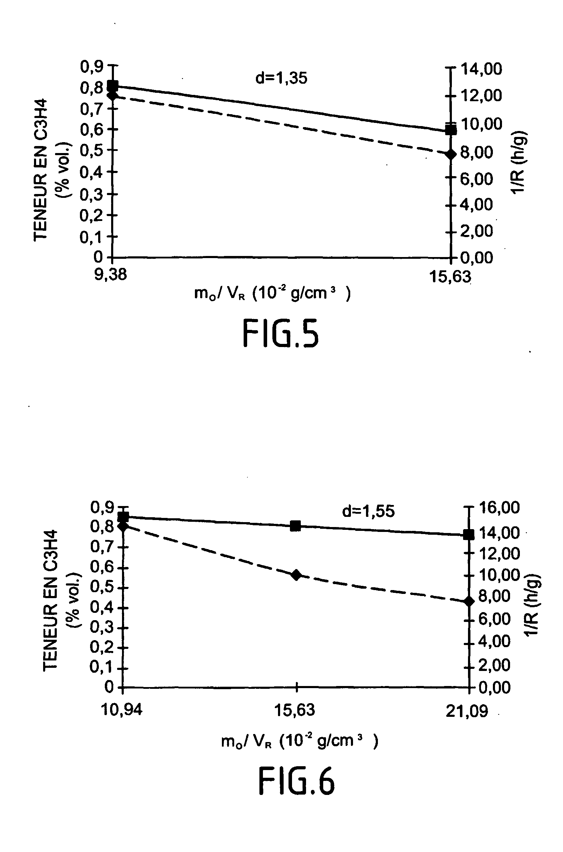

Ces résultats sont reportés sur les courbes des figures 2 à 6 pour les différentes densités d de substrats.

Sur les figures 2 à 6, on a également représenté, en pointillés, les courbes représentant la variation de 1/R en fonction de $m_o/V_R$, R étant la cinétique de dépôt qui s'exprime en g/h.

On constate que la teneur globale en $C_3H_4$ varie en sens inverse de la cinétique de dépôt et qu'il existe une corrélation entre cinétique de dépôt et teneur mesurée. On note aussi que la relation entre masse de substrats et teneur globale en $C_3H_4$ reste toujours vérifiée, mais de façon moins marquée, lorsque la densité augmente, l'influence de la masse de substrats sur la teneur globale en $C_3H_4$ et sur la cinétique de dépôt étant moindre pour des densités de substrats élevées.

### Essais 2

On a procédé comme pour les essais 1, à l'exception du temps de séjour qui est porté à environ 2 s.

Le tableau II ci-dessous indique la teneur totale mesurée en $C_3H_4$ pour les mêmes différents chargements que dans les essais 1.

## Tableau II

| Densité (d) $m_0/V_R$ $10^{-2}$ g/cm$^3$ | 0,4 | 0,7 | 0,9 | 1,35 | 1,55 |
|---|---|---|---|---|---|
| 1,56 | 0,43 | | | | |
| 2,34 | | 0,50 | | | |
| 2,81 | 0,30 | | | | |
| 3,13 | | | 0,48 | | |
| 4,06 | 0,17 | | | | |
| 4,69 | | 0,35 | | | |
| 5,47 | 0,08 | | | | |
| 7,03 | | 0,26 | | | |
| 7,81 | | | 0,32 | | |
| 9,38 | | 0,11 | | 0,56 | |
| 10,94 | | | 0,23 | | 0,59 |
| 15,63 | | | | 0,42 | 0,55 |
| 21,09 | | | | | 0,51 |

Ces résultats confirment les conclusions tirées des essais 1. Ils indiquent en outre une diminution de teneur globale en $C_3H_4$ mesurée par suite de l'augmentation du temps de séjour.

Essais 3

On procède comme pour les essais 1, à l'exception du temps de séjour qui est réduit à 0,75 et de la température qui est de 1 050 °C.
Le tableau III ci-dessous indique la teneur globale mesurée en $C_3H_4$ pour les mêmes différents chargements que dans les essais 1.

## Tableau III

| $m_o/V_R$ $10^{-2}$ g/cm³ \ Densité (d) | 0,4 | 0,7 | 0,9 | 1,35 | 1,55 |
|---|---|---|---|---|---|
| 1,56 | 0,69 | | | | |
| 2,34 | | 0,84 | | | |
| 2,81 | 0,48 | | | | |
| 3,13 | | | 0,79 | | |
| 4,06 | 0,28 | | | | |
| 4,69 | | 0,59 | | | |
| 5,47 | 0,13 | | | | |
| 7,03 | | 0,44 | | | |
| 7,81 | | | 0,53 | | |
| 9,38 | | 0,18 | | 0,90 | |
| 10,94 | | | 0,38 | | 0,92 |
| 15,63 | | | | 0,68 | 0,87 |
| 21,09 | | | | | 0,82 |

Ces résultats confirment les conclusions tirées des essais 1 et 2.

Essais 4

On a procédé comme pour les essais 1, mais en remplaçant $C_3H_8$ par un autre dopant, le butane $C_4H_{10}$, le rapport volumique $CH_4/C_4H_{10}$ étant également de 0,9/0,1.

Le tableau IV ci-dessous indique la teneur globale en $C_3H_4$ mesurée pour les mêmes différents chargements de substrats que dans les essais 1.

## Tableau IV

| Densité (d) $m_o/V_R$ $10^{-2}\,g/cm^3$ | 0,4 | 0,7 | 0,9 | 1,35 | 1,55 |
|---|---|---|---|---|---|
| 1,56 | 0,67 | | | | |
| 2,34 | | 0,80 | | | |
| 2,81 | 0,47 | | | | |
| 3,13 | | | 0,76 | | |
| 4,06 | 0,26 | | | | |
| 4,69 | | 0,55 | | | |
| 5,47 | 0,12 | | | | |
| 7,03 | | 0,41 | | | |
| 7,81 | | | 0,49 | | |
| 9,38 | | 0,16 | | 0,88 | |
| 10,94 | | | 0,36 | | 0,89 |
| 15,63 | | | | 0,64 | 0,84 |
| 21,09 | | | | | 0,80 |

Les résultats sont tout à fait comparables à ceux des essais 1.

Essais 5

On a procédé comme pour les essais 4, mais avec un temps de séjour porté à 2 s.
Le tableau V ci-dessous indique la teneur globale en $C_3H_4$ mesurée pour les mêmes différents chargements que dans les essais 1.

## Tableau V

| Densité (d) $m_o/V_R$ $10^{-2}$ g/cm³ | 0,4 | 0,7 | 0,9 | 1,35 | 1,55 |
|---|---|---|---|---|---|
| 1,56 | 0,47 | | | | |
| 2,34 | | 0,56 | | | |
| 2,81 | 0,33 | | | | |
| 3,13 | | | 0,53 | | |
| 4,06 | 0,18 | | | | |
| 4,69 | | 0,39 | | | |
| 5,47 | 0,08 | | | | |
| 7,03 | | 0,29 | | | |
| 7,81 | | | 0,34 | | |
| 9,38 | | 0,11 | | 0,62 | |
| 10,94 | | | 0,25 | | 0,62 |
| 15,63 | | | | 0,45 | 0,59 |
| 21,09 | | | | | 0,55 |

Les résultats sont tout à fait comparables à ceux des essais 2.

Essais 6

On procède comme pour les essais 3 mais en remplaçant $C_3H_8$ par un autre dopant, l'éthane $C_2H_6$, le rapport volumique $CH_4/C_2H_6$ étant également de 0,9/0,1.

Le tableau VI ci-dessous indique la teneur globale en $C_3H_4$ mesurée pour les mêmes différents chargements que dans les essais 1.

## Tableau VI

| Densité (d) $m_0/V_R$ $10^{-2}$ g/cm$^3$ | 0,4 | 0,7 | 0,9 | 1,35 | 1,55 |
|---|---|---|---|---|---|
| 1,56 | 0,51 | | | | |
| 2,34 | | 0,63 | | | |
| 2,81 | 0,36 | | | | |
| 3,13 | | | 0,59 | | |
| 4,06 | 0,21 | | | | |
| 4,69 | | 0,44 | | | |
| 5,47 | 0,10 | | | | |
| 7,03 | | 0,33 | | | |
| 7,81 | | | 0,40 | | |
| 9,38 | | 0,14 | | 0,68 | |
| 10,94 | | | 0,29 | | 0,69 |
| 15,63 | | | | 0,51 | 0,65 |
| 21,09 | | | | | 0,62 |

On peut tirer des conclusions semblables à celles déduites des essais 1.

Essais 7

On a procédé comme dans l'exemple 1 mais en opérant à une température d'environ 950°C sous une pression d'environ 1,9 kPa.

Le tableau VII ci-après indique la valeur globale mesurée en $C_3H_4$ pour les mêmes différents chargements que dans l'essai 1.

## Tableau VII

| Densité (d) $m_o/V_R$ $10^2$ g/cm$^3$ | 0,4 | 0,7 | 0,9 | 1,35 | 1,55 |
|---|---|---|---|---|---|
| 1,56 | 0,39 | | | | |
| 2,34 | | 0,50 | | | |
| 2,81 | 0,27 | | | | |
| 3,13 | | | 0,47 | | |
| 4,06 | 0,16 | | | | |
| 4,69 | | 0,35 | | | |
| 5,47 | 0,07 | | | | |
| 7,03 | | 0,26 | | | |
| 7,81 | | | 0,32 | | |
| 9,38 | | 0,11 | | 0,54 | |
| 10,94 | | | 0,23 | | 0,55 |
| 15,63 | | | | 0,40 | 0,52 |
| 21,09 | | | | | 0,49 |

Essais 8

On a procédé comme dans l'exemple 7, mais en opérant sous une pression d'environ 1 kPa.
Le tableau VIII ci-dessous indique la valeur globale mesurée en $C_3H_4$ pour les mêmes chargements que dans l'essai 1.

## Tableau VIII

| Densité (d) $m_o/V_R$ $10^{-2} g/cm^3$ | 0,4 | 0,7 | 0,9 | 1,35 | 1,55 |
|---|---|---|---|---|---|
| 1,56 | 0,38 | | | | |
| 2,34 | | 0,48 | | | |
| 2,81 | 0,27 | | | | |
| 3,13 | | | 0,46 | | |
| 4,06 | 0,17 | | | | |
| 4,69 | | 0,34 | | | |
| 5,47 | 0,08 | | | | |
| 7,03 | | 0,25 | | | |
| 7,81 | | | 0,32 | | |
| 9,38 | | 0,11 | | 0,52 | |
| 10,94 | | | 0,24 | | 0,52 |
| 15,63 | | | | 0,40 | 0,51 |
| 21,09 | | | | | 0,48 |

Les résultats des essais 7 et 8 sont très voisins entre eux. La variation de pression entre les essais 7 et 8 semble avoir peu d'influence.

Dans l'art antérieur, les procédés CVI PyC sont traditionnellement mis en oeuvre avec des valeurs fixes des paramètres de densification.

Pour chaque paramètre, on choisit habituellement une valeur intermédiaire entre une première valeur qui serait la valeur optimale pouvant être utilisée au début du processus de densification, lorsque la porosité des substrats est aisément accessible, et une deuxième valeur qui serait la valeur optimale pouvant être utilisée lorsque la diffusion de la phase gazeuse réactionnelle au sein de la porosité des substrats devient moins facile. Ces valeurs optimales sont notamment dictées par le type de microstructure de PyC souhaité. Pour le débit de phase gazeuse réactionnelle, le taux de dopant dans la phase gazeuse, la température et la pression, la première valeur est supérieure à la deuxième. Pour le temps de séjour de la phase gazeuse, c'est l'inverse.

En effet, si l'on choisissait pour chaque paramètre une valeur constante égale à/ou très proche de la valeur optimale en fin de processus, la cinétique de dépôt serait faible et la durée du processus s'en trouverait allongée. Par contre, si l'on choisissait une valeur égale à ou très proche de la valeur optimale au début du processus, cela ne contribuerait pas à augmenter la cinétique de dépôt en fin de processus, la cinétique de dépôt étant alors essentiellement dépendante de la diffusion, mais conduirait, d'une part, à accroître le risque d'obturation prématurée de la porosité par des dépôts de surface et, d'autre part, à favoriser le dépôt de PyC de microstructure indésirable, voire le dépôt de produits indésirables tels que des suies.

Les essais rapportés ci-avant montrent que certaines espèces contenues dans les gaz effluents sont représentatives de la cinétique de dépôt, et que leur teneur dans les gaz effluents varie en fonction de la valeur d'un ou plusieurs paramètres de densification.

Ces constats sont mis à profit conformément à l'invention pour le pilotage du procédé CVI PyC par action sur au moins un paramètre de densification en fonction de la teneur mesurée en une ou plusieurs espèces particulières dans les gaz effluents, de manière à optimiser le processus de densification.

Les espèces concernées sont l'allène, le propyne et le benzène. Les essais rapportés ci-dessus montrent l'influence du temps de séjour et de la température sur la teneur en $C_3H_4$. D'autres essais effectués en l'absence de chargement ont montré que la teneur mesurée en allène et propyne est sensible à la teneur en dopant dans la phase gazeuse, réactionnelle, au débit massique de celle-ci, et que la teneur mesurée en benzène est sensible à la température.

Pour le ou chaque paramètre de densification sur lequel il est choisi d'agir, le réglage est de préférence réalisé à l'intérieur d'une plage de valeurs. Pour les différents paramètres indiqués plus haut, la valeur maximale est celle qui peut être fixée au début du processus de densification. Elle est choisie notamment en fonction des caractéristiques de porosité des substrats à densifier et du type de microstructure de PyC souhaité. La valeur minimale est celle en dessous de laquelle il n'est pas souhaitable ou utile de tomber en fin du processus de densification.

Ainsi, par exemple, pour la densification de substrats fibreux en fibres de carbone couramment utilisés pour la réalisation de pièces en matériau composite C/C, notamment des disques de freins d'avions, et pour la formation de PyC de type laminaire rugueux, les plages de variations de différents paramètres pourront être choisies comme suit :

- température comprise entre 900°C et 1100°C, afin de respecter la microstructure du PyC,
- pression comprise entre 0,1 kPa et 10 kPa afin de respecter la microstructure du PyC et de limiter les contraintes techniques d'établissement et de maintien de très faibles pressions dans le four,
- temps de séjour compris entre 0,5 s et 5 s notamment pour éviter une maturation de la phase gazeuse conduisant à des dépôts parasites,
- dans une phase gazeuse réactionnelle contenant du méthane et un ou plusieurs gaz dopants notamment propane, butane ou éthane, un taux volumique de dopant compris entre 0 % et 70 %, voire entre 0 % et 100 %, la phase gazeuse réactionnelle pouvant être constituée uniquement de dopant au tout début de la densification.

Quant au débit global de phase gazeuse réactionnelle, il est dicté aussi par la masse de substrats fibreux à densifier, pour s'assurer que chaque substrat soit alimenté en phase gazeuse réactionnelle.

Du fait que la cinétique de dépôt, au début du processus de densification est dictée plus par les paramètres de densification que par la capacité de diffusion de la phase gazeuse réactionnelle au sein des substrats, on choisira de préférence comme valeur de départ, pour le ou chaque paramètre variable, la valeur maximale dans la plage préétablie, ou une valeur proche de cette valeur maximale, sauf pour le temps de séjour pour lequel on choisira la valeur minimale ou une valeur proche de cette valeur minimale.

La commande du processus est ensuite effectuée de manière à maintenir la teneur en allène, propyne et/ou benzène à une valeur sensiblement constante et égale à celle mesurée au début du processus de densification. Cette valeur de référence pourra être celle mesurée après plusieurs heures, ou une valeur moyenne de plusieurs mesures effectuées au début du processus, afin d'attendre une stabilisation du processus. Du fait de la lente évolution du processus, il n'est pas nécessaire d'effectuer une mesure en continu de la teneur surveillée. Une mesure périodique, par exemple à intervalle de 0,25 h à 1 h peut être suffisante.

Le maintien de la teneur mesurée à une valeur sensiblement constante peut être satisfait dès lors que la teneur mesurée se maintient dans une plage [T-20 %, T+20 %], où T est la valeur de référence établie au début du processus,

En pratique, le maintien de la teneur mesurée à une valeur sensiblement constante conduit à une diminution progressive du ou des paramètres de densification ajustés au cours du procédé, sauf pour le temps de séjour, lequel augmente.

La fin du processus de densification peut être détectée lorsque le maintien de la teneur mesurée à une valeur sensiblement constante se révèle impossible par réglage du ou des paramètres variables choisi, dans la plage de variation prédéterminée. En pratique, on observe alors généralement une augmentation non maîtrisable de la teneur mesurée. On peut choisir de fixer la fin du processus de densification lorsque la teneur mesurée dépasse un seuil prédéterminé choisi égal ou supérieur à la limite supérieure de la plage autorisée pour cette teneur.

Des exemples de mise en oeuvre du procédé conforme à l'invention, seront maintenant décrits.

On a procédé avec un chargement de plusieurs substrats fibreux de densité initiale égale à 0,4 représentant un rapport $m/V_R$ égal à $5,47.10^{-2}$ $g/cm^3$. On a procédé à la densification des substrats jusqu'à atteindre une densité finale environ égale à 1,6.

## Exemple 9

On a utilisé une phase gazeuse réactionnelle contenant un mélange $CH_4/C_3H_8$. Le processus CVI PyC a été conduit en réglant la température à l'intérieur du four à une valeur égale à environ 1000°C, la pression à une valeur environ égale à 1,3 kPa et le temps de séjour à $1 \pm 0,30$ s, la variation du temps de séjour étant directement liée aux variations de débit.

La teneur des gaz effluents en allène et propyne (teneur globale en $C_3H_4$ a été mesurée de façon périodique et le taux de $C_3H_8$ dans la phase gazeuse a été réglé par commande de la vanne 36 au moyen de l'unité de commande 42 afin de maintenir la teneur mesurée sensiblement égale à 0,2. Le taux de dopant, c'est-à-dire le pourcentage molaire

de $C_3H_8$ dans la phase gazeuse réactionnelle a dû être fixé à 50 % au début du processus.

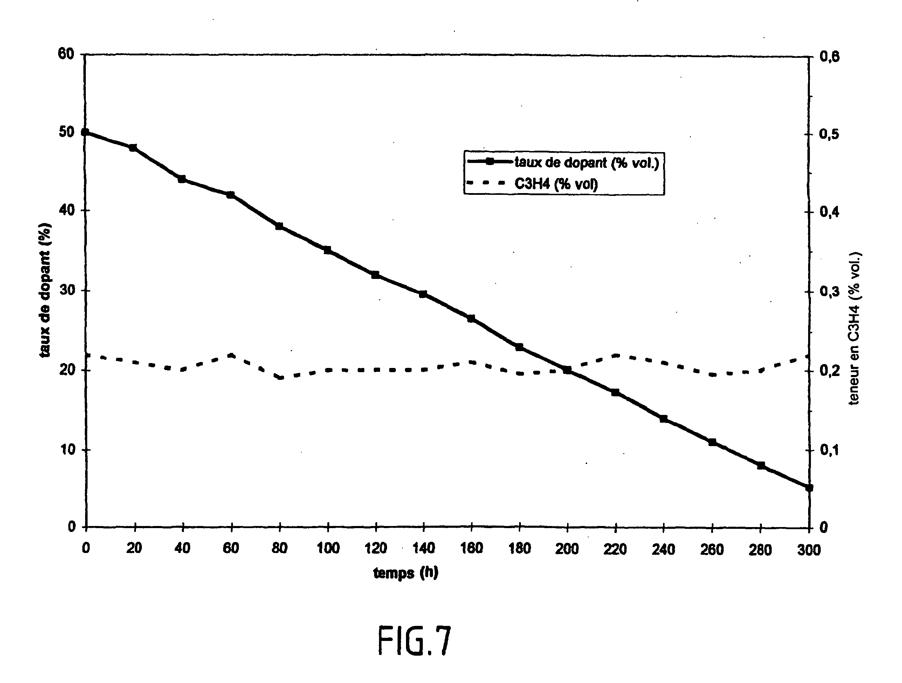

La figure 7 montre l'évolution dans le temps de la teneur mesurée en $C_3H_4$ et du taux de dopant $C_3H_8$. On constate que le maintien de la teneur globale en $C_3H_4$ à une valeur sensiblement constante a conduit à diminuer progressivement le taux de dopant jusqu'à atteindre une valeur d'environ 5 % en fin de processus de densification.

A titre comparatif, un processus CVI PyC a été réalisé dans les mêmes conditions, à l'exception du taux molaire du dopant $C_3H_8$ qui a été maintenu constant et égal à 10 %. La durée nécessaire pour atteindre une densité égale environ à 1,6 a été supérieure de 40 % en comparaison avec le processus CVI PyC à taux de dopant évolutif.

Exemple 10

On a utilisé une phase gazeuse réactionnelle contenant un mélange $CH_4/C_4H_{10}$ avec une proportion volumique de dopant de 10 %. Le processus CVI PyC a été conduit en réglant la pression dans le four à une valeur d'environ 1,0 kPa et le temps de séjour à une valeur d'environ 1 s.

La teneur des gaz effluents en benzène ($C_6H_6$) a été mesurée de façon périodique et la température dans le four a été réglée par commande du circuit d'alimentation 44 par le circuit de commande 42 afin de maintenir la teneur mesurée sensiblement constante et égale à la valeur mesurée au début du processus de densification. La température a été fixée à une valeur de 1100°C au début du processus.

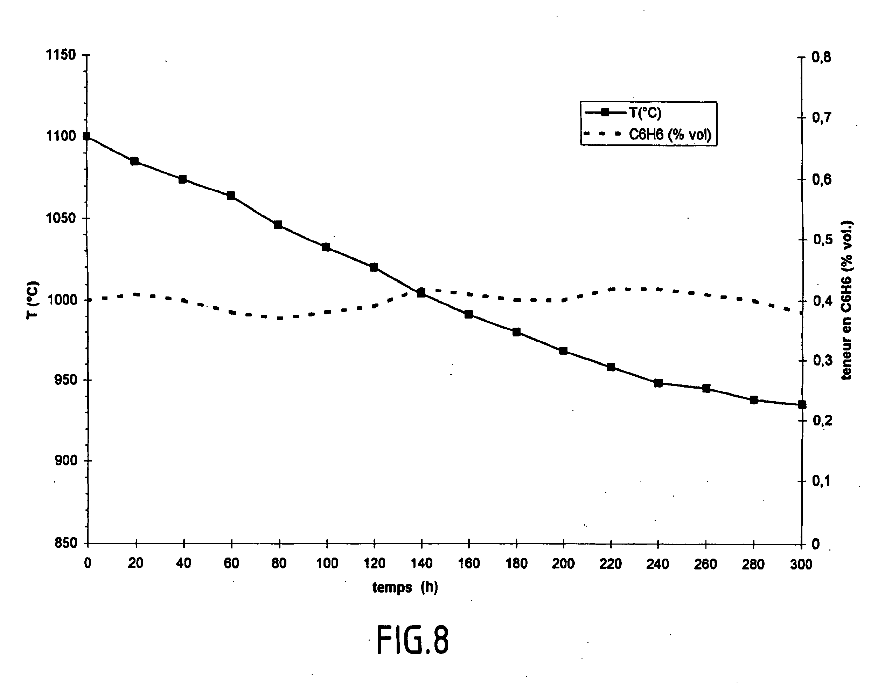

La figure 8 montre l'évolution dans le temps, de la teneur mesurée en $C_6H_6$ et de la température. On constate que le maintien de la teneur mesurée a conduit à diminuer progressivement la température jusqu'à une valeur égale à environ 950°C en fin du processus de densification.

A titre comparatif, un processus CVI PyC a été réalisé dans les mêmes conditions, à l'exception de la température qui a été maintenue constante et égale à environ 1000°C. La durée nécessaire pour atteindre une densité égale environ à 1,6 a été supérieure de 30 % en comparaison avec le processus CVI PyC à température évolutive.

Les exemples 9 et 10 confirment l'efficacité du procédé conforme à l'invention pour réduire la durée de densification par optimisation du processus CVI PyC. Cette diminution de durée s'accompagne d'une diminution de la quantité de phase gazeuse réactionnelle consommée et d'une diminution d'émission de certains produits, tels que des hydrocarbures aromatiques polycycliques, dans les gaz effluents.

Bien que l'on ait envisagé dans les exemples 9 et 10 une action sur un seul paramètre de densification, plusieurs paramètres pourront être variés lors d'un même processus de densification.

Le procédé conforme à l'invention convient pour réaliser une commande ou pilotage en temps réel du processus de densification par mesure de la teneur en allène, propyne et/ou benzène dans les gaz effluents et ajustement d'au moins un paramètre de densification.

Le procédé conforme à l'invention convient aussi pour réaliser une modélisation d'un processus de densification pour une installation donnée d'infiltration chimique en phase vapeur et pour un chargement type de substrats à densifier. Au cours d'un ou plusieurs cycles de densification de modélisation, le procédé est mis en oeuvre avec réglage d'au moins un paramètre de densification en fonction de la teneur mesurée en allène, propyne et/ou benzène. La variation du ou de chaque paramètre de densification réglé est mémorisée, ainsi que la durée du processus de densification. Le modèle ainsi établi est reproduit ensuite lors de processus de densification de mêmes types de chargement de substrats, en répétant la variation du ou des mêmes(s) paramètre(s) de densification et sur la même durée que lors du ou des cycles de modélisation.

Enfin, bien que l'on ait décrit une application à la densification d'un chargement de substrats formé de préformes annulaires empilées, le procédé selon l'invention est bien entendu applicable à la densification d'un ou plusieurs substrats de toutes formes.

**Revendications**

1. Procédé de commande ou modélisation de la densification d'au moins un substrat poreux par du carbone pyrolytique par infiltration chimique en phase vapeur, comprenant : le logement dans un four d'un chargement comprenant un ou plusieurs substrats poreux à densifier ; le chauffage du ou des substrats ; l'admission dans le four d'une phase gazeuse réactionnelle contenant au moins un hydrocarbure précurseur de carbone ; le réglage de la pression dans le four pour permettre à la phase gazeuse de diffuser au sein de la porosité du ou des substrats chauffés afin d'y former un dépôt de carbone pyrolytique ; et l'extraction de gaz effluents hors du four par une conduite d'extraction reliée à une sortie du four ;

   **caractérisé en ce qu'**on mesure la teneur des gaz effluents en au moins un composé choisi parmi l'allène, le propyne et le benzène ; et, en fonction de la teneur mesurée, on commande le procédé par réglage d'au moins un paramètre choisi parmi le débit de phase gazeuse réactionnelle admise dans le four, le débit d'au moins un constituant de la phase gazeuse admise dans le four, le temps de séjour de la phase gazeuse dans le four, la température de chauffage du ou des substrats, et la pression régnant dans le four.

2. Procédé selon la revendication 1, **caractérisé en ce que** le réglage d'au moins un paramètre est réalisé de manière à maintenir la teneur mesurée à une valeur sensiblement constante.

3. Procédé selon l'une quelconque des revendications 1 et 2, **caractérisé en ce que** la teneur est mesurée dans une conduite en dérivation de la canalisation d'extraction.

4. Procédé selon l'une quelconque des revendications 1 à 3, **caractérisé en ce que** la teneur est mesurée par chromatographie en phase gazeuse.

5. Procédé selon l'une quelconque des revendications 1 à 4, **caractérisé en ce que** la commande du procédé est réalisée par réglage du débit de phase gazeuse réactionnelle, ou du débit d'un constituant de la phase gazeuse en fonction de la teneur mesurée en allène et/ou propyne.

6. Procédé selon l'une quelconque des revendications 1 à 4, **caractérisé en ce que** la commande du procédé est réalisée par réglage de la température de chauffage du ou des substrats en fonction de la teneur mesurée en benzène.

7. Procédé selon l'une quelconque des revendications 1 à 6, **caractérisé en ce que** la phase gazeuse réactionnelle comprend au moins un constituant choisi parmi les alcanes, les alcynes et les alcènes.

8. Procédé selon l'une quelconque des revendications 1 à 7, **caractérisé en ce que** la phase gazeuse réactionnelle comprend un précurseur qui est choisi parmi le propane, le butane et l'éthane et qui est dilué dans du méthane.

9. Procédé selon l'une quelconque des revendications 1 à 8, **caractérisé en ce que** le réglage du paramètre choisi est réalisé à l'intérieur d'une plage de valeurs prédéterminée.

10. Procédé selon la revendication 9, **caractérisé en ce que** l'on détecte la fin du processus de densification par l'impossibilité de maîtriser l'évolution de la teneur mesurée par réglage du paramètre choisi.

11. Procédé selon l'une quelconque des revendications 1 à 10, **caractérisé en ce que** la variation du ou de chaque paramètre réglé est mémorisée pour constituer un modèle reproductible lors d'un processus ultérieur de densification d'un même type de chargement.

12. Procédé selon les revendications 10 et 11, **caractérisé en ce que** l'on mémorise également la durée du processus de densification.

**Claims**

1. A method of controlling or modeling the process of densifying at least one porous substrate with pyrolytic carbon by chemical vapor infiltration, the process comprising: placing a load comprising one or more porous substrates to be densified in an oven; heating the substrate(s); admitting a reaction gas into the oven, the reaction gas containing at least one carbon-precursor hydrocarbon; adjusting the pressure in the over so as to enable the gas to diffuse within the pores of the heated substrate (s) so as to form a deposit of pyrolytic carbon therein; and extracting effluent gas frond the oven via an extraction pipe connected to an outlet from the oven; the method being **characterized by** measuring the content in the effluent gas of at least one compound selected from allene, propine, and benzene; and, as a function of the measured content, by controlling the process by adjusting at least one parameter selected from: the flow rate of the reaction gas admitted into the oven, the flow rate of at least one component of the gas admitted into the oven, the transit time of the gas through the oven, the temperature to which the substrate(s) is/are heated, and the pressure that exists inside the oven.

2. The method according to claim 1, **characterized in that** at least one parameter is adjusted so as to maintain the measured content at a value that is substantially constant.

3. A method according to claim 1 or claim 2, **characterized in that** the content is measured in a duct in parallel with the extraction pipe.

**4.** A method according to any of claims 1 to 3, **characterized in that** the content is measured by gas chromatography.

**5.** A method according to any one of claims 1 to 4, **characterized in that** the method is controlled by adjusting the flow rate of the reaction gas, or the flow rate of a component of the reaction gas as a function of the measured allene and/or propine content.

**6.** A method according to any one of claims 1 to 4, **characterized in that** the method is controlled by adjusting the temperature to which the substrate(s) is/are heated as a function of the measured benzene content.

**7.** A method according to any one of claims 1 to 6, **characterized in that** the reaction gas comprises at least one component selected from alkanes, alkynes, and alkenes.

**8.** A method according to any one of claims 1 to 7, **characterized in that** the reaction gas comprises a precursor which is selected from propane, butane, and ethane and which is diluted in methane.

**9.** A method according to any one of claims 1 to 8, **characterized in that** the selected parameter is adjusted within a predetermined range of values.

**10.** A method according to claim 9, **characterized in that** the end of the densification process is detected by it becoming impossible to control the variation in the measured content by adjusting the selected parameter.

**11.** A method according to any one of claims to 10, **characterized in that** the variation in the or each adjusted parameter is stored so as to constitute a model that is reproducible during a subsequent process of densifying a load of the same type.

**12.** method according to claims 10 and 11, **characterized in that** the duration of the densification process is also stored.

**Patentansprüche**

**1.** Verfahren zu Steuerung oder Modellierung der Verdichtung wenigstens eines porösen Substrats durch pyrolytischen Kohlenstoff mittels chemischer Gasphaseninfiltration, umfassend: das Unterbringen einer Ladung, die ein oder mehrere zu verdichtende poröse Substrate umfaßt, in einem Ofen, das Erhitzen des oder der Substrate, das Einleiten einer reaktiven Gasphase, die wenigstens einen Kohlenwasserstoff als Kohlenstoffvorläufer umfaßt, in den Ofen, das Einstellen des Druckes in dem Ofen, um der Gasphase zu ermöglichen, in die Poren des oder der erhitzten Substrate zu dringen, um dort einen Niederschlag aus pyrolytischem Kohlenstoff zu bilden, sowie das Abzieher von Abgasen aus dem Ofen über eine mit einem Auslaß des Ofens verbundene Abzugsleitung, **dadurch gekennzeichnet, daß** der Gehalt der Abgase in wenigstens einer Verbindung, welche aus Allen, Propin und Benzol ausgewählt ist, gemessen wird und in Abhängigkeit von dem gemessenen Gehalt das Verfahren durch Einstellen wenigstens eines Parameters, welcher aus der Menge der in den Ofen eingeleiteten reaktiven Gasphase, der Menge wenigstens eines Bestandteils der in den Ofen eingeleiteten Gasphase, der Verweildauer der Gasphase in dem Ofen, der Temperatur zum Erhitzen des oder der Substrate und dem in dem Ofen herrschenden Druck ausgewählt ist, gesteuert wird.

**2.** Verfahren nach Anspruch 1, **dadurch gekennzeichnet, daß** die Einstellung wenigstens eines Parameters derart erfolgt, daß der gemessene Gehalt auf einem im wesentlichen konstanten Wert gehalten wird.

**3.** Verfahren nach einem der Ansprüche 1 und 2, **dadurch gekennzeichnet, daß** der Gehalt in einer der Abzugsrohrleitung gemessen wird.

**4.** Verfahren nach einem der Ansprüche 1 bis 3, **dadurch gekennzeichnet, daß** der Gehalt mittels Gaschromatographie gemessen wird.

**5.** Verfahren nach einem der Ansprüche 1 bis 4, **dadurch gekennzeichnet, daß** die Steuerung des Verfahrens durch Einstellung der Menge der reaktiven Gasphase oder der Menge eines Bestandteils der Gasphase in Abhängigkeit von dem gemessenen Allen- und/oder Propingehalt vollzogen wird.

**6.** Verfahren nach einem der Ansprüche 1 bis 4, **dadurch gekennzeichnet, daß** die Steuerung des Verfahrens durch Einstellung der Temperatur zum Erhitzen des oder der Substrate in Abhängigkeit von dem gemessenen Benzolgehalt vollzogen wird.

7. Verfahren nach einem der Ansprüche 1 bis 6, **dadurch gekennzeichnet, daß** die reaktive Gasphase wenigstens einen Bestandteil, welcher aus den Alkanen, Alkinen und Alkenen ausgewählt ist, umfaßt.

8. Verfahren nach einem der Ansprüche 1 bis 7, **dadurch gekennzeichnet, daß** die reaktive Gasphase einen Vorläufer umfaßt, der aus Propan, Butan und Ethan ausgewählt ist und der in Methan verdünnt ist.

9. Verfahren nach einem der Ansprüche 1 bis 8, **dadurch gekennzeichnet, daß** die Einstellung des gewählten Parameters innerhalb eines vorbestimmten Wertebereichs vollzogen wird.

10. Verfahren nach Anspruch 9, **dadurch gekennzeichnet, daß** das Ende des Verdichtungsprozesses **dadurch** erkannt wird, daß es unmöglich ist, die Entwicklung des gemessenen Gehaltes durch Einstellung des gewählten Parameters zu steuern.

11. Verfahren nach einem der Ansprüche 1 bis 10, **dadurch gekennzeichnet, daß** die Änderung des oder eines jeden eingestellten Parameters gespeichert wird, um ein Modell zu bilden, das bei einem späteren Prozeß zur Verdichtung einer gleichen Ladungsart reproduzierbar ist.

12. Verfahren nach den Ansprüchen 10 und 11, **dadurch gekennzeichnet, daß** auch die Dauer des Verdichtungsprozesses gespeichert wird.

FIG.1

FIG.2

FIG.3

FIG.4

FIG.5

FIG.6

FIG.7

FIG.8

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2711647 A
- US 5348774 A

- US 6001419 A